(19) Europäisches Patentamt
European Patent Office
Office européen des brevets

(11) **EP 4 780 170 A1**

(12) **EUROPEAN PATENT APPLICATION**
published in accordance with Art. 153(4) EPC

(43) Date of publication:
**22.07.2026 Bulletin 2026/30**

(21) Application number: **24865419.6**

(22) Date of filing: **10.09.2024**

(51) International Patent Classification (IPC):
**H10F 71/00** (2025.01)   **H10F 10/167** (2025.01)
**H10K 30/40** (2023.01)   **H10K 30/50** (2023.01)
**H10K 30/85** (2023.01)

(52) Cooperative Patent Classification (CPC):
**H10F 10/00; H10F 10/162; H10F 10/167;
H10K 30/10; H10K 30/40; H10K 30/50;
H10K 30/85; H10K 71/16; H10K 85/50;**
Y02E 10/541; Y02P 70/50

(86) International application number:
**PCT/JP2024/032300**

(87) International publication number:
**WO 2025/057919 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **11.09.2023 JP 2023146957**

(71) Applicants:
• **PXP Corporation
Sagamihara-shi, Kanagawa 252-0203 (JP)**

• **SOLABLE Inc.
Tokyo 100-7014 (JP)**

(72) Inventors:
• **SUGIMOTO, Hiroki
Sagamihara-shi, Kanagawa 252-0203 (JP)**
• **FUKASAWA, Kazuhito
Sagamihara-shi, Kanagawa 252-0203 (JP)**
• **KAWAHARA, Mayo
Sagamihara-shi, Kanagawa 252-0203 (JP)**

(74) Representative: **EIP
Fairfax House
15 Fulwood Place
London WC1V 6HU (GB)**

(54) **METHOD FOR MANUFACTURING SOLAR CELL AND SOLAR CELL**

(57)    Provided are a method for manufacturing a solar cell and a solar cell, which achieve both high performance and high productivity. The present disclosure relates to a method for manufacturing a solar cell, including a step of forming an electron transport layer on a substrate including a light absorption layer by depositing an n-type oxide semiconductor is formed by a sputtering method while supplying a gas including an oxygen source and a hydrogen source.

[Fig.1]

Fig. 1

## Description

### Technical Field

The present invention relates to a method for manufacturing a solar cell and a solar cell.

### Background Art

As one type of solar cell, a compound-type solar cell using a chalcopyrite compound, a kesterite compound, a perovskite compound, or the like is known.
The compound-type solar cell has a structure in which a p-type light absorption layer and an n-type hetero material as an electron transport layer are laminated. As the n-type layer, cadmium sulfide is generally used.
In Non-Patent Literatures 1 and 2, it is studied to use an n-type oxide semiconductor such as zinc oxide, tin oxide, titanium oxide, zinc oxysulfide, magnesium zinc oxide, tin zinc oxide, and titanium zinc oxide instead of the cadmium sulfide as the electron transport layer.

### Citation List

### Non-Patent Literatures

Non-Patent Literature 1: E.B. Yousfi et al., Cadmium-free buffer layers deposited by atomic layer epitaxy for copper indium diselenide solar cells, Thin Solid Films, 361-362, 183-186 (2000)
Non-Patent Literature 2: Soumyadeep Sinha et al., A review on atomic layer deposited buffer layers for Cu(In,Ga) Se2(CIGS) thin film solar cells: Past, present, and future, Solar Energy, 209, 515-537 (2020)

### Summary of Invention

### Technical Problem

However, when the n-type oxide semiconductor is used instead of the cadmium sulfide as the electron transport layer, a resistance tends to be high, and performance tends to be deteriorated as compared with the solar cell using the cadmium sulfide. In addition, when the n-type oxide semiconductor is formed into a film as the electron transport layer, as a sputtering method having excellent mass productivity is used, it is difficult to improve the performance, and as an atomic layer deposition method capable of manufacturing a high-performance solar cell is used, it is difficult to improve the productivity.
The present invention has been made in view of the above-described problems, and an object thereof is to provide a method for manufacturing a solar cell and a solar cell, which achieve both high performance and high productivity.

### Solution to Problem

A method for manufacturing a solar cell according to an aspect of the present invention includes a step of forming an electron transport layer on a substrate including a light absorption layer by depositing an n-type oxide semiconductor by a sputtering method while supplying a gas including an oxygen source and a hydrogen source.
The present inventors have found that one of the factors that deteriorate the performance of the solar cell when the n-type oxide semiconductor is formed as a film by a sputtering method is that deposition damage occurs on a surface of a target substrate on which the n-type oxide semiconductor is formed. In the method for manufacturing a solar cell according to the aspect of the present invention, by depositing the n-type oxide semiconductor while supplying the gas including not only the oxygen source but also the hydrogen source, the damage caused to the substrate by the sputtering can be reduced or suppressed. As a result, a high-performance solar cell can be manufactured with high productivity.
A solar cell according to an aspect of the present invention includes at least, in the following order, a first electrode layer, a light absorption layer, an electron transport layer being an n-type oxide semiconductor to which a hydrogen element is added, and a second electrode layer.
In the solar cell, by using the n-type oxide semiconductor to which a hydrogen element is added as the electron transport layer, the electron transport layer can be formed by the sputtering while reducing or suppressing the deposition damage to a lower layer of the electron transport layer. As a result, the solar cell can achieve both high performance and high productivity.

## Advantageous Effect of Invention

According to the present invention, it is possible to provide a method for manufacturing a solar cell and a solar cell, which achieve both high performance and high productivity.

## Brief Description of Drawings

[Figure 1] Figure 1 is a schematic cross-sectional view of a solar cell according to an embodiment of the present invention.
[Figure 2] Figure 2 is a schematic cross-sectional view of a solar cell according to another embodiment of the present invention.
[Figure 3] Figure 3 is a diagram illustrating a relationship between atmosphere conditions in the step of forming an n-type oxide semiconductor and deposition damage by sputtering.

## Description of Embodiments

Hereinafter, embodiments (hereinafter, referred to as "the present embodiments") for carrying out the present invention will be described in detail with reference to drawings as necessary. However, the present invention is not limited thereto, and various modifications are possible without departing from the gist. Incidentally, in the drawings, the same elements will be represented by the same reference numerals, and redundant descriptions thereof will be omitted. Unless otherwise specifically described, the positional relationship such as vertical or horizontal one will be based on the positional relationship illustrated in the drawings. The dimensional ratios illustrated in the drawings are not limited to the depicted ratios.

[Solar cell]

The solar cell according to the present embodiment includes at least, in the following order, a first electrode layer, a light absorption layer, an electron transport layer that is an n-type oxide semiconductor to which a hydrogen element is added, and a second electrode layer. The solar cell may include a layer other than these layers, and may include a plurality of these layers.

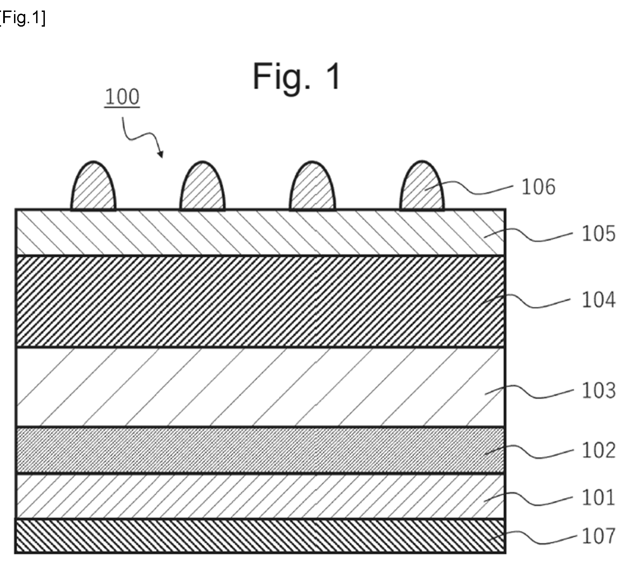

Figure 1 is a schematic cross-sectional view of the solar cell according to an embodiment. A solar cell 100 of the embodiment illustrated in Figure 1 includes a substrate 107, a first electrode layer 101 provided on the substrate 107, a hole transport layer 102 provided on the first electrode layer 101, a light absorption layer 103 provided on the hole transport layer 102, an electron transport layer 104 provided on the light absorption layer 103, a second electrode layer 105 provided on the electron transport layer 104, and a grid electrode 106 provided on the second electrode layer 105. The solar cell 100 typically receives light from the second electrode layer 105 side to generate power.

In the solar cell 100 according to the present embodiment, the electron transport layer 104 is an n-type oxide semiconductor to which a hydrogen element is added. Therefore, it is presumed that, as described in detail in [Method for manufacturing solar cell], the electron transport layer 104 can be formed by sputtering while reducing or suppressing the deposition damage that occurs on the light absorption layer 103 when the electron transport layer 104 is formed as a film on the light absorption layer 103. As a result, the solar cell can achieve both high performance and high productivity. However, the present invention is not limited to the above-described presumption.

A thickness of the solar cell 100, excluding the substrate 107, is not particularly limited, and is, for example, 1.0 $\mu$m or more and 10.0 $\mu$m or less, 1.1 $\mu$m or more and 8.0 $\mu$m or less, or 1.2 $\mu$m or more and 6.0 $\mu$m or less. The solar cell 100 according to the present embodiment can be a thin film solar cell by forming each layer to be sufficiently thin.

Hereinafter, each configuration that can be included in the solar cell 100 will be described in detail.

In the present specification, when each layer or a semiconductor included in each layer is expressed by a name of a certain compound, not only the pure compound itself but also a compound doped with a trace amount of an element or the like in a range in which the characteristics of the compound are not lost is included.

In addition, in the present embodiment, since the element in each layer of the solar cell can be present in different oxidation states, all the oxidation states are referred to by the name of the element unless otherwise specified. For example, "hydrogen element" may mean a hydrogen atom, a hydrogen ion, a hydride ion, hydrogen in the form of a compound, and hydrogen in an elemental state.

(Substrate)

The substrate 107 is not particularly limited, and for example, a glass substrate such as soda-lime glass and low alkali glass, a metal substrate such as a stainless steel plate and an aluminum foil, or a resin substrate such as a polyimide resin substrate and an epoxy resin substrate can be used. A thickness of the substrate 107 is not particularly limited, and is, for example, 10 $\mu$m or more and 500 $\mu$m or less, 20 $\mu$m or more and 250 $\mu$m or less, or 30 $\mu$m or more and 100 $\mu$m or less. When the thickness of the substrate 107 is within the above-described range, the solar cell tends to be lightened or flexible.

(First electrode layer)

The first electrode layer 101 is provided, for example, to extract a current caused by holes generated in the light absorption layer 103 described later. The first electrode layer 101 is not particularly limited as long as it has conductivity, and for example, a metal conductive layer using a metal such as Mo, Cr, and Ti as a material; a conductive inorganic compound layer using a conductive inorganic compound other than the metal as a material; or a conductive organic compound layer using a conductive organic compound as a material can be used. A thickness of the first electrode layer 101 is not particularly limited, and is, for example, 200 nm or more and 800 nm or less, or 300 nm or more and 700 nm or less. When the thickness of the first electrode layer 101 is within the above-described range, the solar cell tends to be lightened or flexible while the current can be sufficiently extracted without loss.

(Hole transport layer)

The solar cell 100 according to the present embodiment includes the hole transport layer 102, but may not include the hole transport layer 102. The hole transport layer 102 has, for example, a function of efficiently extracting the holes generated in the light absorption layer 103 described later from the light absorption layer 103, and preventing electrons generated at the same time as the holes in the light absorption layer 103 described later from recombining with the holes. The hole transport layer 102 is preferably a p-type semiconductor. A substance contained in the p-type semiconductor is not particularly limited, and examples thereof include organic compounds including polythiophene derivatives such as poly(3,4-ethylenedioxythiophene):polystyrene sulfonate (PEDOT:PSS), poly(3-hexylthiophene) (P3HT), and poly(3-octylthiophene) (P3OT), fluorene derivatives such as 2,2'-7,7'-tetrakis(N,N-di-p-methoxyphenylamine)-9,9'-spirobifluorene (spiro-MeO-TAD), carbazole derivatives such as polyvinylcarbazole, triphenylamine derivatives, diphenylamine derivatives, polysilane derivatives, polyaniline derivatives, and the like; and inorganic compounds such as nickel oxide, molybdenum oxide, copper gallium oxide, copper aluminum oxide, molybdenum selenide, and molybdenum selenosulfide. The p-type semiconductor in the hole transport layer 102 may be used alone or in combination of two or more kinds thereof.

The hole transport layer 102 is preferably substantially composed of the above-described organic compound or inorganic compound, and is preferably formed of the above-described organic compound or inorganic compound. In addition, a content of the above-described organic compound or inorganic compound in the hole transport layer 102 is preferably 80% by mass or more and 100% by mass or less, 90% by mass or more and 100% by mass or less, 95% by mass or more and 100% by mass or less, or 99% by mass or more and 100% by mass or less with respect to the total amount of the hole transport layer 102.

A thickness of the hole transport layer 102 is preferably 10 nm or more and 100 nm or less, 15 nm or more and 80 nm or less, or 20 nm or more and 60 nm or less. When the thickness of the hole transport layer 102 is within the above-described range, the solar cell tends to be lightened or flexible while the hole transport layer 102 has a function of efficiently extracting the holes generated in the light absorption layer 103 described later from the light absorption layer 103, and preventing electrons generated at the same time as the holes in the light absorption layer 103 described later from recombining with the holes.

(Light absorption layer)

The light absorption layer 103 has, for example, a function of absorbing near-infrared light, visible light, ultraviolet light, or the like to generate electrons and holes. Examples of the near-infrared light, visible light, ultraviolet light, or the like include sunlight. The light absorption layer 103 preferably contains a perovskite compound, a chalcopyrite compound, or a kesterite compound. The perovskite compound may be used alone or in combination of two or more kinds thereof. The chalcopyrite compound may be used alone or in combination of two or more kinds thereof. The kesterite compound may be used alone or in combination of two or more kinds thereof.

Examples of the perovskite compound include a compound represented by General Formula $AMX_3$ and a compound represented by General Formula $A_2MX_4$. Here, M represents a divalent cation, A represents a monovalent cation, and X represents a monovalent anion.

The monovalent cation A is not particularly limited, and examples thereof include a cation of an element of Group 1 in the periodic table and an organic cation. Among the above, a cesium ion, a rubidium ion, an ammonium ion (including an amidinium ion) which may have a substituent, a phosphonium ion which may have a substituent, or an amidinium ion which may have a substituent is preferable. Examples of the ammonium ion which may have a substituent include a primary ammonium ion and a secondary ammonium ion. Specific examples of the ammonium ion which may have a substituent include an alkylammonium ion, an arylammonium ion, an amidinium ion, and a guanidinium ion. In particular, in order to avoid steric hindrance, a monoalkylammonium ion is preferable, and from the viewpoint of improving stability, an alkylammonium ion substituted with one or more fluorine atoms is preferably used. In addition, a combination of two or more kinds of cations can also be used as the cation A. Examples of the monovalent cation A include a methylammonium ion, a monofluoromethylammonium ion, a difluoromethylammonium ion, a trifluoromethylammonium ion, an ethylammonium ion, an isopropylammonium ion, an n-propylammonium ion, an isobutylammonium ion, an n-butylammonium ion, a t-butylammonium ion, a dimethylammonium ion, a diethylammonium ion, a phenylammonium ion, a benzylammonium ion, a phenethylammonium ion, a guanidinium ion, a formamidinium ion, an acetamidinium ion, and an imidazolium ion.

The divalent cation M is not particularly limited, and examples thereof include a divalent metal cation and a metalloid cation. Specific examples thereof include a cation of an element of Group 14 in the periodic table, and more specific examples thereof include a lead cation ($Pb^{2+}$), a tin cation ($Sn^{2+}$), and a germanium cation ($Ge^{2+}$). In addition, a combination of two or more kinds of cations can also be used as the cation M.

The monovalent anion X is not particularly limited, and examples thereof include a halide ion, an acetate ion, a nitrate ion, a sulfate ion, a borate ion, an acetylacetonate ion, a carbonate ion, a citrate ion, a sulfur ion, a tellurium ion, a thiocyanate ion, a titanate ion, a zirconate ion, a 2,4-pentanedionate ion, and a fluorosilicate ion. X may be one kind of anion or a combination of two or more kinds of anions. As X, a halide ion or a combination of a halide ion and another anion is preferably used. Examples of the halide ion X include a chloride ion, a bromide ion, and an iodide ion.

Examples of the perovskite compound include an organic-inorganic perovskite compound, and particularly, a halide-based organic-inorganic perovskite compound. Specific examples of the perovskite compound include $CH_3NH_3PbI_3$, $CH_3NH_3PbBr_3$, $CH_3NH_3PbCl_3$, $CH_3NH_3SnI_3$, $CH_3NH_3SnBr_3$, $CH_3NH_3SnCl_3$, $CH_3NH_3PbI_{(3-x)}Cl_x$, $CH_3NH_3PbI_{(3-x)}Br_x$, $CH_3NH_3PbBr_{(3-x)}Cl_x$, $CH_3NH_3Pb_{(1-y)}Sn_yI_3$, $CH_3NH_3Pb_{(1-y)}Sn_yBr_3$, $CH_3NH_3Pb_{(1-y)}Sn_yCl_3$, $CH_3NH_3Pb_{(1-y)}Sn_yI_{(3-x)}Cl_x$, $CH_3NH_3Pb_{(1-y)}Sn_yI_{(3-x)}Br_x$, $CH_3NH_3Pb_{(1-y)}Sn_yBr_{(3-x)}Cl_x$, and compounds in which $CFH_2NH_3$, $CF_2HNH_3$, $CF_3NH_3$, or $NH_2CH=NH_2$ is used instead of $CH_3NH_3$ in the compounds. In the formulae, x represents any value of 0 or more and 3 or less, and y represents any value of 0 or more and 1 or less.

Preferred examples of the chalcopyrite compound include an $I$-$III$-$VI_2$ group chalcopyrite compound. The $I$-$III$-$VI_2$ group chalcopyrite compound is not particularly limited, and examples thereof include $CuAlS_2$, $CuAlSe_2$, $CuAlTe_2$, $CuGaS_2$, $CuGaSe_2$, $CuGaTe_2$, $CuInS_2$, $CuInSe_2$, $CuInTe_2$, $AgAlS_2$, $AgAlSe_2$, $AgAlTe_2$, $AgGaS_2$, $AgGaSe_2$, $AgGaTe_2$, $AgInS_2$, $AgInSe_2$, $AgInTe_2$, and combinations thereof. The "combinations thereof" is not particularly limited, and examples thereof include $Cu(In_xGa_{1-x})(Se_yS_{1-y})_2$ ($0 \leq x \leq 1$, $0 \leq y \leq 1$) when $CuGaS_2$ and $CuInSe_2$ are combined. Among these chalcopyrite compounds, $CuGaS_2$, $CuGaSe_2$, $CuInS_2$, $CuInSe_2$, or $Cu(In_xGa_{1-x})(Se_yS_{1-y})_2$ ($0 \leq x \leq 1$, $0 \leq y \leq 1$) is preferable, and $Cu(In_xGa_{1-x})(Se_yS_{1-y})_2$ ($0 \leq x \leq 1$, $0 \leq y \leq 1$) is more preferable. In the present embodiment, a CIS compound is a chalcopyrite compound including Cu, In, and Se, a CIGS compound is a chalcopyrite compound including Cu, In, Ga, and Se, and a CIGSS compound is a chalcopyrite compound including Cu, In, Ga, Se, and S.

Preferred examples of the kesterite compound include an $I_2$-$II$-$IV$-$VI_4$ group kesterite compound. The $I_2$-$II$-$IV$-$VI_4$ group kesterite compound is not particularly limited, and examples thereof include $Cu_2ZnSnS_4$, $Cu_2ZnSnSe_4$, $Cu_2ZnGeS_4$, $Cu_2ZnGeSe_4$, $Cu_2MnSnS_4$, $Cu_2MnSnSe_4$, $Cu_2MnGeS_4$, $Cu_2MnGeSe_4$, $Ag_2ZnSnS_4$, $Ag_2ZnSnSe_4$, $Ag_2ZnGeS_4$, $Ag_2ZnGeSe_4$, $Ag_2MnSnS_4$, $Ag_2MnSnSe_4$, $Ag_2MnGeS_4$, $Ag_2MnGeSe_4$, and combinations thereof. The "combinations thereof" is not particularly limited, and examples thereof include $(Cu_xAg_{1-x})_2ZnSn(S_ySe_{1-y})_4$ ($0 \leq x \leq 1$) when $Cu_2ZnSnS_4$ and $Ag_2ZnSnSe_4$ are combined. Examples thereof also include $Cu_2ZnSn(S_xSe_{1x})_4$ ($0 \leq x \leq 1$, $0 \leq y \leq 1$). Among these kesterite compounds, $Cu_2ZnSnS_4$, $Cu_2ZnSnSe_4$, $Ag_2ZnSnS_4$, $Ag_2ZnSnSe_4$, or $(Cu_xAg_{1-x})_2ZnSn(S_ySe_{1-y})_4$ ($0 \leq x \leq 1$, $0 \leq y \leq 1$) is preferable, and $(Cu_xAg_{1-x})_2ZnSn(S_ySe_{1-y})_4$ ($0 \leq x \leq 1$, $0 \leq y \leq 1$) is more preferable. In the present embodiment, a CZTS compound is a kesterite compound including Cu, Zn, Sn, and S, an ACZTS compound is a kesterite compound including Ag, Cu, Zn, Sn, and S, and an ACZTSS compound is a kesterite compound including Ag, Cu, Zn, Sn, S, and Se.

A content of the perovskite compound, the chalcopyrite compound, or the kesterite compound in the light absorption layer 103 is not particularly limited as long as the light absorption layer 103 has the function of absorbing visible light, ultraviolet light, or the like to generate electrons and holes. More specifically, the content thereof is not particularly limited, and is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less with respect to the total mass of the light absorption layer 103.

The light absorption layer 103 may contain an additive such as a binder and a surfactant, in addition to the above-described material. A content of the above-described additive is not particularly limited, and is, for example, 0.1 to 10% by mass with respect to the total mass of the light absorption layer 103. The light absorption layer 103 may not contain the above-described additive.

A thickness of the light absorption layer 103 is preferably 0.5 $\mu$m or more and 10.0 $\mu$m or less, 0.5 $\mu$m or more and 7.5 $\mu$m or less, 0.5 $\mu$m or more and 5.0 $\mu$m or less, or 0.5 $\mu$m or more and 3.0 $\mu$m or less. When the thickness of the light absorption layer 103 is within the above-described range, the solar cell tends to be lightened or flexible while the light absorption layer 103 has the function of absorbing visible light, ultraviolet light, or the like to generate electrons and holes.

The solar cell 100 according to the present embodiment may include two layers of the light absorption layer 103. In this case, a substance contained in the first light absorption layer 103 and a substance contained in the second light absorption layer 103 may be different from or the same as each other, but are preferably different from each other. When the solar cell 100 includes two layers of the light absorption layer 103, a wavelength range of light that can be absorbed by the light absorption layer 103 tends to be expanded, and as a result, the performance of the solar cell tends to be improved. In addition, the solar cell 100 according to the present embodiment may include three or more layers of the light absorption layer 103.

(Electron transport layer)

The electron transport layer 104 is an n-type oxide semiconductor to which a hydrogen element is added, and has a function of efficiently extracting the electrons generated in the light absorption layer 103 from the light absorption layer 103 and preventing holes generated at the same time as the electrons in the light absorption layer 103 from recombining with the electrons.

A band gap of the n-type oxide semiconductor to which a hydrogen element is added is preferably 3.3 eV or more, 3.4 eV or more, 3.5 eV or more, or 3.6 eV or more. In addition, the band gap of the n-type oxide semiconductor to which a hydrogen element is added is not particularly limited, and is, for example, 3.3 eV or more and 5.0 eV or less, 3.4 eV or more and 4.5 eV or less, or 3.5 eV or more and 4.0 eV or less. When the band gap is within the above-described numerical range, the transmittance of the electron transport layer 104 is improved, so that the amount of light absorbed by the light absorption layer 103 is increased, and as a result, the conversion efficiency of the solar cell tends to be improved.

As a method of measuring the band gap, a known method can be used. More specifically, the band gap is measured by, for example, a spectroscopic transmittance measurement, a spectroscopic quantum efficiency measurement, or the like; but the present invention is not particularly limited thereto.

A carrier concentration of the n-type oxide semiconductor to which a hydrogen element is added is preferably 1.0 x $10^{20}$ cm$^{-3}$ or less, 5.0 x $10^{19}$ cm$^{-3}$ or less, or 2.5 x $10^{19}$ cm$^{-3}$ or less. In addition, the carrier concentration of the n-type oxide semiconductor to which a hydrogen element is added is not particularly limited, and is, for example, 1.0 x $10^{16}$ cm$^{-3}$ or more and 1.0 x $10^{20}$ cm$^{-3}$ or less, 1.0 x $10^{17}$ cm$^{-3}$ or more and 5.0 x $10^{19}$ cm$^{-3}$ or less, or 1.0 x $10^{18}$ cm$^{-3}$ or more and 2.5 x $10^{19}$ cm$^{-3}$ or less. When the carrier concentration is within the above-described numerical range, the electrons generated in the light absorption layer 103 can be efficiently extracted from the light absorption layer 103, so that it is possible to prevent holes generated at the same time as the electrons in the light absorption layer 103 from recombining with the electrons, and as a result, the conversion efficiency of the solar cell tends to be improved.

As a method of measuring the carrier concentration, a known method can be used. More specifically, the carrier concentration is measured by, for example, a Hall measurement or the like; but the present invention is not particularly limited thereto.

A refractive index of the n-type oxide semiconductor to which a hydrogen element is added is not particularly limited. The refractive index of the n-type oxide semiconductor is, for example, 1.8 or more, preferably 2.1 or more. In addition, the refractive index is not particularly limited, and is, for example, 1.8 or more and 3.0 or less, 2.1 or more and 2.8 or less, or 2.1 or more and 2.6 or less. It is preferable that the refractive index of the electron transport layer 104 is appropriately adjusted such that the difference from the refractive index with an adjacent layer is not too large.

As a method of measuring the refractive index, a known method can be used. More specifically, the refractive index is measured by, for example, a spectroscopic transmittance measurement, a spectroscopic ellipsometry measurement, or the like; but the present invention is not particularly limited thereto.

A specific resistivity of the n-type oxide semiconductor to which a hydrogen element is added is preferably 1.6 x $10^{-2}$ $\Omega$cm or more, 1.8 x $10^{-2}$ $\Omega$cm or more, or 2.0 x $10^{-2}$ $\Omega$cm or more. In addition, the specific resistivity of the n-type oxide semiconductor to which a hydrogen element is added is not particularly limited, and is, for example, 1.6 x $10^{-2}$ $\Omega$cm or more and 1.0 x $10^{2}$ $\Omega$cm or less, 1.8 x $10^{-2}$ $\Omega$cm or more and 10.0 $\Omega$cm or less, or 2.0 x $10^{-2}$ $\Omega$cm or more and 1.0 $\Omega$cm or less. When the specific resistivity is within the above-described numerical range, the conversion efficiency of the solar cell tends to be improved.

As a method of measuring the specific resistivity, a known method can be used. More specifically, the specific resistivity is measured by, for example, a four-probe method; but the present invention is not particularly limited thereto.

As the n-type oxide semiconductor to which a hydrogen element is added, a semiconductor having a band gap of 3.3 eV or more and a carrier concentration of 1.0 x $10^{20}$ cm$^{-3}$ or less is preferable. Furthermore, as the n-type oxide semiconductor to which a hydrogen element is added, a semiconductor having a band gap of 3.3 eV or more, a carrier concentration of $1.0 \times 10^{20}$ cm$^{-3}$ or less, and a specific resistivity of $1.6 \times 10^{-2}$ $\Omega$cm or more is preferable.

Preferred examples of a substance contained in the n-type oxide semiconductor as the n-type oxide semiconductor to which a hydrogen element is added and having a band gap of 3.3 eV or more, a carrier concentration of $1.0 \times 10^{20}$ cm$^{-3}$ or less, and a specific resistivity of $1.6 \times 10^{-2}$ $\Omega$cm or more include zinc oxide, tin oxide, titanium oxide, zinc oxysulfide (zinc oxide to which a sulfur element is added), magnesium zinc oxide (zinc oxide to which a magnesium element is added), tin zinc oxide (zinc oxide to which a tin element is added), and titanium zinc oxide (zinc oxide to which a titanium element is added). Among the above, titanium zinc oxide (zinc oxide to which a titanium element is added) is preferable. The n-type oxide semiconductor may be used alone or in combination of two or more kinds thereof.

Regarding the zinc oxide to which a sulfur element is added, from the viewpoint of more reliably exhibiting the function of the electron transport layer 104, a molar ratio of the sulfur element to the oxygen element is preferably 0 or more and 0.7 or less, or 0.1 or more and 0.4 or less.

Regarding the zinc oxide to which a magnesium element is added, from the viewpoint of more reliably exhibiting the function of the electron transport layer 104, a molar ratio of the magnesium element to the zinc element is preferably 0 or more and 0.4 or less, or 0.1 or more and 0.3 or less.

Regarding the zinc oxide to which a tin element is added, from the viewpoint of more reliably exhibiting the function of the electron transport layer 104, a molar ratio of the tin element to the zinc element is preferably 0 or more and 1.0 or less, or 0.2 or more and 0.4 or less.

Regarding the zinc oxide to which a titanium element is added, from the viewpoint of more reliably exhibiting the function of the electron transport layer 104, a molar ratio of the titanium element to the zinc element is preferably 0 or more and 0.3 or less, or 0.05 or more and 0.2 or less.

In the n-type oxide semiconductor to which a hydrogen element is added, from the viewpoint of more reliably exhibiting the function of the electron transport layer 104, a molar ratio of the hydrogen element to all metal elements is preferably 0.001 or more and 0.030 or less, 0.005 or more and 0.020 or less, 0.007 or more and 0.015 or less, or 0.009 or more and 0.013 or less.

The electron transport layer 104 that is the n-type oxide semiconductor to which a hydrogen element is added may be an electron transport layer formed by a method in an electron transport layer-forming step described later.

The electron transport layer 104 that is the n-type oxide semiconductor is preferably substantially composed of zinc oxide, tin oxide, titanium oxide, zinc oxysulfide, magnesium zinc oxide, tin zinc oxide, or titanium zinc oxide, and is preferably zinc oxide, tin oxide, titanium oxide, zinc oxysulfide, magnesium zinc oxide, tin zinc oxide, or titanium zinc oxide. In addition, a content of the zinc oxide, tin oxide, titanium oxide, zinc oxysulfide, magnesium zinc oxide, tin zinc oxide, or titanium zinc oxide in the electron transport layer 104 that is the n-type oxide semiconductor is preferably 80% by mass or more and 100% by mass or less, 90% by mass or more and 100% by mass or less, 95% by mass or more and 100% by mass or less, or 99% by mass or more and 100% by mass or less with respect to the total amount of the electron transport layer 104.

A thickness of the electron transport layer 104 is preferably 50 nm or more and 150 nm or less, 55 nm or more and 140 nm or less, 60 nm or more and 135 nm or less, or 65 nm or more and 130 nm or less. When the thickness of the electron transport layer 104 is within the above-described range, the solar cell tends to be lightened or flexible while the electron transport layer 104 has the function of efficiently extracting the electrons generated in the light absorption layer 103 from the light absorption layer 103 and preventing holes generated at the same time as the electrons in the light absorption layer 103 from recombining with the electrons.

(Second electrode layer)

The second electrode layer 105 is provided, for example, to extract a current caused by the electrons generated in the light absorption layer 103. In the solar cell 100, typically, since the light absorption layer 103 absorbs light passing through the second electrode layer 105, the second electrode layer 105 is preferably a transparent electrode layer in order to increase the amount of light absorbed by the light absorption layer 103. The transparent electrode is an electrode using a material having both high electrical conductivity and high visible light transmittance. The high electrical conductivity is not particularly limited, and means, for example, that a specific resistivity is $5.0 \times 10^{-3}$ $\Omega$cm or less. The high visible light transmittance is not particularly limited, and means, for example, that an average transmittance in a wavelength range of 400 to 1,300 nm is 80% or more. As a material for the transparent electrode, a known material can be used, and examples thereof include indium tin oxide (ITO), hydrogen-containing indium oxide (IOH), fluorine-containing tin oxide (FTO), boron-containing zinc oxide (ZnO:B), and aluminum-containing zinc oxide (ZnO:Al).

A content of the above-described material when the second electrode layer 105 is the transparent electrode is not particularly limited as long as the second electrode layer 105 functions as the transparent electrode. More specifically, the content of the above-described material is not particularly limited, and is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less, or 95% by mass or more and 100% by mass or less with respect to the total mass of the second electrode layer 105.

A thickness of the second electrode layer 105 is not particularly limited, and is, for example, 100 nm or more and 1,500 nm or less, or 200 nm or more and 1,000 nm or less. When the thickness of the second electrode layer 105 is within the above-described range, the solar cell tends to be lightened or flexible while the current can be sufficiently extracted without loss.

(Grid electrode)

The grid electrode 106 is provided, for example, to extract electricity from the second electrode layer 105, and may not be provided. A material for the grid electrode 106 is not particularly limited as long as it has conductivity, and for example, a metal such as Mo, Cr, Ag, Cu, Ni, Al, and Ti; a conductive inorganic compound other than the metal; or a conductive organic compound can be used.

A content of the above-described material in the grid electrode 106 is not particularly limited as long as the grid electrode 106 functions as an electrode. More specifically, the content of the above-described material is not particularly limited, and is 50% by mass or more and 100% by mass or less, 60% by mass or more and 100% by mass or less, 70% by mass or more and 100% by mass or less, 80% by mass or more and 100% by mass or less, 90% by mass or more and 100% by mass or less with respect to the total mass of the grid electrode 106.

A thickness of the grid electrode 106 is not particularly limited, and is, for example, 5 $\mu$m or more and 50 $\mu$m or less. When the thickness of the grid electrode 106 is within the above-described range, the solar cell tends to be lightened or flexible while the current can be sufficiently extracted without loss.

[Modified examples]

The solar cell 100 illustrated in Figure 1 provided merely to explain the present invention and are not intended to limit the present invention to the embodiment. Various modifications are possible without departing from the scope and spirit of the present invention.

For example, in the solar cell 100 according to the present embodiment, two sets or three or more sets of laminates may be formed on the first electrode layer 101, wherein the laminate has the hole transport layer 102, the light absorption layer 103 provided on the hole transport layer 102, the electron transport layer 104 provided on the light absorption layer 103, and the second electrode layer 105 provided on the electron transport layer 104 as one set. In addition, the grid electrode 106 may be provided on the uppermost second electrode layer 105.

When a plurality of layers is present among the layers 101 to 107, the plurality of layers may be the same as or different from each other. For example, when a plurality of light absorption layers is provided, each light absorption layer may contain a compound having a different absorption spectrum, and the electron transport layer and the hole transport layer in contact with each light absorption layer may be selected according to properties of the light absorption layer in contact therewith.

In addition, the solar cell 100 according to the present embodiment may include another layer between the layers, on the grid electrode 106, or under the substrate 107 as necessary. For example, the hole transport layer 102 may include two or more hole transport layers containing different materials, and may include, on the grid electrode 106, a contamination prevention layer for preventing contamination from the outside. In addition, the electron transport layer 104 may include two or more electron transport layers containing different materials. However, at least one of the layers is the n-type oxide semiconductor to which a hydrogen element is added.

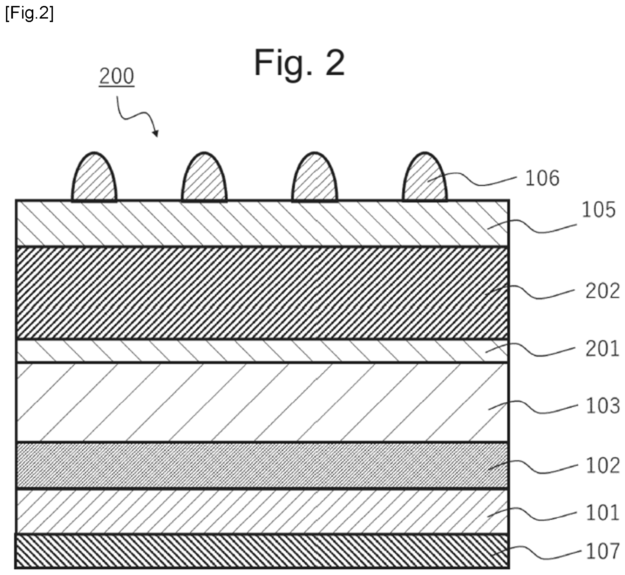

Figure 2 is a schematic cross-sectional view of a solar cell according to an embodiment in which two electron transport layers are provided. A solar cell 200 of the embodiment illustrated in Figure 2 includes a substrate 107, a first electrode layer 101 provided on the substrate 107, a hole transport layer 102 provided on the first electrode layer 101, a light absorption layer 103 provided on the hole transport layer 102, a first electron transport layer 201 provided on the light absorption layer 103, a second electron transport layer 202 provided on the first electron transport layer 201, a second electrode layer 105 provided on the second electron transport layer 202, and a grid electrode 106 provided on the second electrode layer 105. The solar cell 200 typically receives light from the second electrode layer 105 side to generate power.

The solar cell 200 illustrated in Figure 2 is different from the solar cell 100 illustrated in Figure 1 in that the first electron transport layer 201 and the second electron transport layer 202 are provided instead of the electron transport layer 104. The other configurations may be the same as in the solar cell 100.

(Electron transport layer)

The solar cell 200 includes the first electron transport layer 201 and the second electron transport layer 202. At least one of the first electron transport layer 201 and the second electron transport layer 202 is an n-type oxide semiconductor to which a hydrogen element is added. Either the first electron transport layer 201 or the second electron transport layer 202 may be the n-type oxide semiconductor to which a hydrogen element is added, or both the first electron transport layer 201 and the second electron transport layer 202 may be the n-type oxide semiconductor to which a hydrogen element is added. When the first electron transport layer 201 or the second electron transport layer 202 is the n-type oxide semiconductor to which a hydrogen element is added, examples and preferred aspects of the n-type oxide semiconductor are similar to or the same as those for the electron transport layer 104.

Either the first electron transport layer 201 or the second electron transport layer 202 may be an electron transport layer other than the n-type oxide semiconductor to which a hydrogen element is added. Such an electron transport layer is preferably an n-type semiconductor. A substance contained in the n-type semiconductor is not particularly limited, and examples thereof include an oxide semiconductor such as zinc oxide, tin oxide, titanium oxide, zinc oxysulfide, magnesium zinc oxide, tin zinc oxide, and titanium zinc oxide; a sulfide semiconductor such as cadmium sulfide, indium oxysulfide, and indium sulfide; and an organic compound such as ethoxylated polyethyleneimine (PEIE) and polyethyleneimine (PEI). Among the above, a sulfide semiconductor is preferable, and cadmium sulfide or indium sulfide is preferable. The n-type semiconductor in the first electron transport layer 201 and the second electron transport layer 202 may be used alone or in combination of two or more kinds thereof.

The electron transport layer other than the n-type oxide semiconductor to which a hydrogen element is added is preferably substantially composed of the above-described oxide semiconductor, sulfide semiconductor, or organic compound, and is preferably the above-described oxide semiconductor, sulfide semiconductor, or organic compound. In addition, a content of the above-described oxide semiconductor, sulfide semiconductor, or organic compound in the electron transport layer other than the n-type oxide semiconductor to which a hydrogen element is added is preferably 80% by mass or more and 100% by mass or less, 90% by mass or more and 100% by mass or less, 95% by mass or more and 100% by mass or less, or 99% by mass or more and 100% by mass or less with respect to the total amount of the electron transport layer.

As described in detail in [Method for manufacturing solar cell], it is presumed that, when the n-type oxide semiconductor to which a hydrogen element is added is formed as the electron transport layer, the deposition damage to a lower layer of the n-type oxide semiconductor can be reduced or suppressed. In addition, the n-type oxide semiconductor to which a hydrogen element is added is less likely to suffer deposition damage when another layer is formed thereon. Therefore, when the first electron transport layer 201 is the n-type oxide semiconductor to which a hydrogen element is added, the deposition damage to the light absorption layer 103 can be reduced or suppressed. Furthermore, the first electron transport layer 201 is resistant to the deposition damage when forming the second electron transport layer 202. When the second electron transport layer 202 is the n-type oxide semiconductor to which a hydrogen element is added, the deposition damage to the first electron transport layer 201 can be reduced or suppressed. Furthermore, the second electron transport layer 202 is resistant to the deposition damage when forming the second electrode layer 105.

In one aspect of the solar cell 200, the first electron transport layer 201 is the n-type oxide semiconductor to which a hydrogen element is added. In this aspect, the n-type oxide semiconductor to which a hydrogen element is added is provided on the light absorption layer 103.

In one aspect of the solar cell 200, the second electron transport layer 202 is the n-type oxide semiconductor to which a hydrogen element is added. In this aspect, when the first electron transport layer 201 is not the n-type oxide semiconductor to which a hydrogen element is added, an electron transport layer different from the n-type oxide semiconductor to which a hydrogen element is added is provided between the light absorption layer 103 and the second electron transport layer 202 that is the n-type oxide semiconductor to which a hydrogen element is added.

When the first electron transport layer 201 or the second electron transport layer 202 is the n-type oxide semiconductor to which a hydrogen element is added, a thickness of the first electron transport layer 201 or the second electron transport layer 202 is preferably 40 nm or more and 140 nm or less, 50 nm or more and 130 nm or less, or 55 nm or more and 120 nm or less.

When the first electron transport layer 201 or the second electron transport layer 202 is not the n-type oxide semiconductor to which a hydrogen element is added, a thickness of the first electron transport layer 201 or the second electron transport layer 202 may be adjusted according to the function of the electron transport layer or the material contained therein, and is, for example, 10 nm or more and 60 nm or less, 15 nm or more and 50 nm or less, or 20 nm or more and 40 nm or less.

[Method for manufacturing solar cell]

(Electron transport layer-forming step)

A method for manufacturing the solar cell according to the present embodiment includes a step (hereinafter, also referred to as "electron transport layer-forming step") of forming an electron transport layer on a substrate including a light absorption layer by depositing an n-type oxide semiconductor by a sputtering method while supplying a gas including an oxygen source and a hydrogen source.

The present inventors have found that one of the factors that deteriorate the performance of the solar cell when the n-type oxide semiconductor is formed as a film by a sputtering method is that, due to the deposition by the sputtering method, deposition damage occurs on a target substrate on which the n-type oxide semiconductor is formed. In the method for manufacturing the solar cell according to the present embodiment, by depositing the n-type oxide semiconductor while supplying the gas including not only the oxygen source but also the hydrogen source, the deposition damage caused to the substrate by the sputtering can be reduced or suppressed, and as a result, a high-performance solar cell can be manufactured with high productivity. The present inventors have estimated that one of the factors of the effect of reducing or suppressing the deposition damage by the supply of the gas including the hydrogen source is that the hydrogen source captures an active species of oxygen generated on a surface of the substrate during the sputtering. That is, when the oxide semiconductor is deposited by the sputtering method, the gas including the oxygen source is supplied, but the present inventors have hypothesized that one of the factors of the deposition damage is that the active species generated from the oxygen source damages the surface of the substrate for forming the oxide semiconductor. As a result of intensive studies, the present inventors have found a method of forming an appropriate n-type oxide semiconductor as the electron transport layer while capturing the active species, and have found that the method is depositing the n-type oxide semiconductor by the sputtering method while supplying the gas including the hydrogen source. The above-described prediction and hypothesis are for describing the present invention, and are not intended to limit the present invention.

The method for manufacturing the solar cell according to the present embodiment can have the following advantages as compared with the method for manufacturing a solar cell in the related art. As described above, when the electron transport layer is formed by the sputtering method by the method in the related art, the deposition damage occurs to the lower layer of the electron transport layer, so that the method for manufacturing a solar cell in the related art uses a high-cost film formation method such as an atomic layer deposition method and a chemical solution deposition method when forming the electron transport layer. On the other hand, in the method for manufacturing the solar cell according to the present embodiment, since the electron transport layer can be formed by the sputtering method suitable for mass production, a high-performance solar cell can be manufactured with high productivity. In addition, the film formation method such as the chemical solution deposition method is a wet process, whereas most of the steps of the method for manufacturing a solar cell are dry processes. Therefore, as compared with the method of forming the electron transport layer by the wet process, the method for manufacturing the solar cell according to the present embodiment can form the electron transport layer by the dry process, so that the time required for the manufacturing can be further shortened. In the present specification, the wet process means a step using a solution. In addition, the dry process means a step using no solution.

The deposition damage caused to the substrate by the sputtering can be evaluated by measuring a remaining factor of open-circuit voltage as shown in Example 1. That is, the deposition damage can be evaluated by measuring an open-circuit voltage of the solar cell manufactured by the manufacturing method according to the present embodiment and the solar cell (control example) in which the electron transport layer is formed by the chemical solution deposition method under standard test conditions, and calculating a value of the open-circuit voltage of the solar cell manufactured by the manufacturing method according to the present embodiment with the open-circuit voltage of the solar cell of the control example as a reference. The standard test conditions of the solar cell are test conditions in which light having an AM 1.5 solar spectrum is incident at an irradiance of 1 kW/$m^2$ and the solar cell temperature is 25°C. The electron transport layer of the solar cell (control example) in which the electron transport layer is formed by the chemical solution deposition method may be a layer of an n-type oxide semiconductor containing cadmium sulfide, having the same thickness as the electron transport layer of the comparative solar cell.

In the method for manufacturing the solar cell according to the present embodiment and the electron transport layer-forming step, the remaining factor of open-circuit voltage is preferably 60% or more, 70% or more, 75% or more, 80% or more, 85% or more, or 90% or more. In the manufacturing method according to the present embodiment, since the electron transport layer is formed by the sputtering method while supplying the gas including the oxygen source and the hydrogen source, the deposition damage to the substrate can be reduced or suppressed even though the electron transport layer is formed by the sputtering method. Therefore, it is considered that a high level of open-circuit voltage can be maintained as compared with the solar cell in which the electron transport layer is formed by the chemical solution deposition method instead of the sputtering method.

As a reference of the remaining factor of open-circuit voltage, a solar cell in which the electron transport layer is formed by the atomic layer deposition method may be used instead of the solar cell in which the electron transport layer is formed by the chemical solution deposition method. In the method for manufacturing the solar cell according to the present embodiment and the electron transport layer-forming step, the value of the open-circuit voltage of the solar cell manufactured by the manufacturing method according to the present embodiment with the solar cell in which the electron transport layer is formed by the atomic layer deposition method as a reference is preferably 60% or more, 70% or more, 75% or more, 80% or more, 85% or more, or 90% or more.

In the electron transport layer-forming step, the electron transport layer is formed on a substrate including a light absorption layer, in which an n-type oxide semiconductor is deposited by the sputtering method while supplying the gas including the oxygen source and the hydrogen source. More specifically, the n-type oxide semiconductor is deposited on the substrate using an appropriate sputtering target while heating the substrate including the light absorption layer and supplying the gas including the oxygen source and the hydrogen source.

The substrate on which the n-type oxide semiconductor is deposited may be any substrate including the light absorption layer; and is preferably a substrate including the light absorption layer and a first electrode, more preferably a substrate having a laminated structure in which the light absorption layer, a hole transport layer, and a first electrode are laminated in this order, and still more preferably a substrate having a laminated structure in which the light absorption layer, a hole transport layer, a first electrode, and a substrate are laminated in this order.

In one embodiment, the substrate may include the light absorption layer on a surface, and in this case, the n-type oxide semiconductor is deposited on the light absorption layer. In one embodiment, the substrate may include an electron transport layer on a surface, and in this case, the n-type oxide semiconductor is deposited on the electron transport layer. The substrate may be, for example, a laminate in which the light absorption layer, a hole transport layer, a first electrode, and a substrate are laminated in this order, a laminate in which an electron transport layer, the light absorption layer, a hole transport layer, a first electrode, and a substrate are laminated in this order, or any laminate in which the hole transport layer is not included in the above laminates. When the laminate as the substrate includes an electron transport layer, the electron transport layer may be an electron transport layer that is an n-type oxide semiconductor to which a hydrogen element is added, or may be another electron transport layer. Specifically, the electron transport layer may be the first electron transport layer 201 in the solar cell 200. By using the substrate as described above, the solar cell can be manufactured more easily.

The electron transport layer, the light absorption layer, the hole transport layer, the first electrode, and the substrate, which may be included in the substrate, may be the same as or similar to the first electron transport layer 201, the light absorption layer 103, the hole transport layer 102, the first electrode layer 101, and the substrate 107.

The sputtering target in the electron transport layer-forming step may contain an element contained in the n-type oxide semiconductor to be formed, and preferably contains a metal element contained in the n-type oxide semiconductor to be formed, and preferably contains an oxide of a metal contained in the n-type oxide semiconductor to be formed. For example, titanium zinc oxide (zinc oxide to which a titanium element is added) can be deposited by using a mixture of titanium oxide and zinc oxide as the sputtering target. In addition, the n-type oxide semiconductor including a sulfur element can be deposited by using a sputtering target containing a sulfide of a metal contained in the n-type oxide semiconductor to be deposited. A content of the metal element and a content of the other element including the oxygen element and the sulfur element in the n-type oxide semiconductor to be deposited can be controlled, for example, by adjusting the element to be added to the sputtering target.

In one embodiment, the sputtering target is a mixture of titanium oxide and zinc oxide. As a result, titanium zinc oxide (zinc oxide to which a titanium element is added) can be deposited. A content of the titanium oxide in the sputtering target is preferably 4.0% by mass or more and 20% by mass or less, 5.0% by mass or more and 19% by mass or less, or 6.0% by mass or more and 18% by mass or less with respect to the total mass of the mixture. In addition, the remainder may be a content of zinc oxide.

The gas supplied in the electron transport layer-forming step includes the oxygen source and the hydrogen source. The gas may have an inert gas, preferably argon gas, as a main component. The oxygen source is not particularly limited as long as it is a gas including an oxygen element, and examples thereof include $H_2O$ vapor, $O_2$ gas, and $O_3$ gas; and $O_2$ gas is preferable. The hydrogen source is not particularly limited as long as it is a gas including a hydrogen element, and examples thereof include $H_2O$ vapor and $H_2$ gas; and $H_2$ gas is preferable.

A concentration of the oxygen source in the supplied gas is preferably 0.12% by volume or more and 2.0% by volume or less, 0.40% by volume or more and 1.8% by volume or less, 0.70% by volume or more and 1.6% by volume or less, 0.80% by volume or more and 1.5% by volume or less, 0.90% by volume or more and 1.5% by volume or less, or 1.0% by volume or more and 1.5% by volume or less in terms of oxygen molecules. The concentration of the oxygen source in terms of oxygen molecules is specifically calculated as follows. When the oxygen source is $H_2O$ vapor, since the $H_2O$ vapor includes one oxygen element, as a concentration of the $H_2O$ vapor in the above-described gas is 1.0% by volume, the concentration of the oxygen source in terms of oxygen molecules is 0.5% by volume, which is half of 1.0% by volume. When the oxygen source is $O_2$ gas, since the $O_2$ gas includes two oxygen elements, as a concentration of the $O_2$ gas in the above-described gas is 1.0% by volume, the concentration of the oxygen source in terms of oxygen molecules is 1.0% by volume.

A molar ratio (H/O) of the hydrogen element to the oxygen element in the supplied gas is preferably 0.60 or more and 4.0 or less, 0.80 times or more and 3.0 times or less, 1.0 times or more and 2.5 times or less, 1.2 times or more and 2.0 times or less, or 1.3 times or more and 1.8 times or less. The molar ratio of the hydrogen element to the oxygen element is specifically calculated as follows. Regarding the gas in which $O_2$ gas is used as the oxygen source and $H_2O$ vapor is used as the hydrogen source, when the concentration of the oxygen source in the gas is 0.8% by volume and the concentration of the hydrogen source in the gas is 1.6% by volume, $H_2O$ vapor as the hydrogen source has two hydrogen elements and one oxygen element per molecule, and $O_2$ gas as the oxygen source has two oxygen elements per molecule. Therefore, the molar ratio of the hydrogen element to the oxygen element is calculated as $(1.6 \times 2) \div (1.6 + 0.8 \times 2) = 1.0$ times. When

$O_2$ gas is used as the oxygen source and $H_2$ gas is used as the hydrogen source, a volume ratio of $O_2$ gas and $H_2$ gas corresponds to the molar ratio.

The oxygen source and the hydrogen source of the supplied gas particularly preferably satisfy the following condition (1) or (2).

(1) The concentration of the oxygen source is 0.80% by volume or more and 1.6% by volume or less in terms of oxygen molecules, and when the concentration of the oxygen source (value in terms of oxygen molecules, % by volume) is denoted by y and the molar ratio (H/O) of the hydrogen element to the oxygen element is denoted by x, the following expression is satisfied:

$$0.85y + 0.1 \leq x \leq 3.0y - 0.9$$

(2) The concentration of the oxygen source is 0.12% by volume or more and less than 0.80% by volume in terms of oxygen molecules, and when the concentration of the oxygen source (value in terms of oxygen molecules, % by volume) is denoted by y and the molar ratio (H/O) of the hydrogen element to the oxygen element is denoted by x, the following expression is satisfied:

$$0.78 \leq x \leq -2.2y + 3.3$$

A concentration of an inert gas (for example, an argon gas) in the supplied gas is not particularly limited, and is, for example, 90.0% by volume or more and 99.0% by volume or less, 91.0% by volume or more and 98.5% by volume or less, 92.0% by volume or more and 98.0% by volume or less, 93.0% by volume or more and 97.5% by volume or less, or 94.0% by volume or more and 97.0% by volume or less. The remainder excluding the oxygen source and the hydrogen source may be an inert gas.

In the electron transport layer-forming step, it is preferable to perform a sputtering treatment while heating the substrate including the light absorption layer. A heating temperature (heat source temperature) is not particularly limited, and is, for example, 80°C or higher and 230°C or lower, and is preferably 100°C or higher and 200°C or lower, or 120°C or higher and 180°C or lower. When a metal substrate is used as the substrate, the temperature of the substrate and the temperature of the heating are substantially the same.

Other deposition conditions of the sputtering method may be adjusted according to the kind of the n-type oxide semiconductor to be deposited or the kind of the sputtering target. For example, the applied power may be 0.5 to 3.0 $W/cm^2$, and the deposition pressure may be 0.5 to 3.0 Pa. In addition, a temperature of the atmosphere may not be controlled during the sputtering.

The method for manufacturing the solar cell according to the present embodiment may include a step of preparing the substrate including the light absorption layer, and the above-described electron transport layer-forming step following the step. The method for manufacturing the solar cell according to the present embodiment may include a step of forming another layer on the electron transport layer after the above-described electron transport layer-forming step.

The step of preparing the substrate including the light absorption layer may include at least one of a step of forming the first electrode layer, a step of forming the hole transport layer, a step of forming the light absorption layer, and a step of forming the electron transport layer. The step of forming another layer on the electron transport layer may include at least one of a step of forming another electron transport layer, a step of forming a second electrode layer, and a step of forming a grid electrode.

The method for manufacturing the solar cell according to the present embodiment may include at least the step of forming the first electrode layer, the step of forming the light absorption layer, the above-described electron transport layer-forming step, and the step of forming the second electrode layer in this order.

Hereinafter, each step that can be included in the method for manufacturing the solar cell according to the present embodiment will be described in detail with reference to Figures 1 and 2 as necessary.

(First electrode layer-forming step)

In a first electrode layer-forming step, for example, the first electrode layer 101 may be formed on the substrate 107. Examples of a method of forming the first electrode layer 101 include the dry process and the wet process, and the dry process is preferable. The dry process is not particularly limited, and examples thereof include a method of forming the first electrode layer 101 that is the metal conductive layer by a sputtering method. Deposition conditions of the sputtering method are not particularly limited, and may be, for example, applied power: 1.0 to 3.0 $W/cm^2$, deposition atmosphere: argon atmosphere, and deposition pressure: 0.5 to 3.0 Pa. In addition, a temperature of the atmosphere and a temperature of a substrate to be sputtered during the sputtering may not be controlled. The substrate to be sputtered is a substrate on a stage when performing the sputtering, and is a substrate on which a compound derived from a sputtering target is laminated. In the first electrode layer-forming step, for example, the substrate 107 may be used as the substrate to be sputtered.

(Hole transport layer-forming step)

In a hole transport layer-forming step, for example, the hole transport layer 102 may be formed on the first electrode layer 101. Examples of a method of forming the hole transport layer 102 include the dry process and the wet process, and the dry process is preferable. The dry process is not particularly limited, and examples thereof include a method of forming the hole transport layer 102 that is a p-type semiconductor containing an organic compound or an inorganic compound by a sputtering method. Deposition conditions of the sputtering method are not particularly limited, and may be, for example, applied power: 0.5 to 3.0 W/cm$^2$, deposition atmosphere: argon atmosphere, and deposition pressure: 0.5 to 3.0 Pa. In addition, a temperature of the atmosphere and a temperature of the substrate to be sputtered during the sputtering may not be controlled. In addition, when forming the light absorption layer 103, a method of forming a compound of the element of the first electrode layer 101 and the element included in the light absorption layer 103 and forming the hole transport layer 102 between the first electrode layer 101 and the light absorption layer 103 may be used.

(Light absorption layer-forming step)

In a light absorption layer-forming step, for example, the light absorption layer 103 may be formed on the hole transport layer 102. When the hole transport layer 102 is not provided, the light absorption layer 103 may be formed on the first electrode layer 101. Examples of a method of forming the light absorption layer 103 include the dry process and the wet process, and the dry process is preferable. The dry process is not particularly limited, and examples thereof include a method of forming the light absorption layer 103 containing a perovskite compound, a chalcopyrite compound, or a kesterite compound by a sputtering method. Deposition conditions of the sputtering method are not particularly limited, and may be, for example, applied power: 0.5 to 3.0 W/cm$^2$, deposition atmosphere: argon atmosphere, and deposition pressure: 0.5 to 3.0 Pa. In addition, a temperature of the atmosphere and a temperature of the substrate to be sputtered during the sputtering may not be controlled. In addition, the laminate after the sputtering may be annealed at 350°C or higher and 650°C or lower in a nitrogen atmosphere or in an atmosphere containing selenium and sulfur.

When the light absorption layer 103 includes the alkali metal element, it is preferable that the light absorption layer-forming step forms the light absorption layer 103 containing a perovskite compound, a chalcopyrite compound, or a kesterite compound by the sputtering method using a sputtering target to which the alkali metal element is added. In addition, a method of adding the alkali metal element to the substrate 107 or the first electrode layer 101 and thermally diffusing the alkali metal element to the light absorption layer 103 when forming the light absorption layer 103 may be used.

(Additional electron transport layer-forming step)

The method for manufacturing the solar cell according to the present embodiment may include an additional electron transport layer-forming step in addition to the above-described electron transport layer-forming step. When the additional electron transport layer-forming step is included, the solar cell 200 including the first electron transport layer 201 and the second electron transport layer 202 as illustrated in Figure 2 can be formed. The additional electron transport layer-forming step may be a step of forming an electron transport layer on a substrate including a light absorption layer, in which an n-type oxide semiconductor is deposited by a sputtering method while supplying a gas including an oxygen source and a hydrogen source, as in the above-described electron transport layer-forming step, or may be a step of forming an electron transport layer by a method different from the above-described electron transport layer-forming step.

In the additional electron transport layer-forming step, for example, the first electron transport layer 201 may be formed on the light absorption layer 103, and the second electron transport layer 202 may be formed on the first electron transport layer 201, which is formed in the above-described electron transport layer-forming step.

Examples of the step of forming the electron transport layer by a method different from the above-described electron transport layer-forming step include a step of forming an n-type oxide semiconductor by a sputtering method while supplying a gas not including a hydrogen source, and a step of forming an n-type oxide semiconductor by a method other than the sputtering method.

Deposition conditions of the sputtering method are not particularly limited, and may be, for example, applied power: 0.5 to 3.0 W/cm$^2$, deposition atmosphere: argon atmosphere capable of including oxygen, and deposition pressure: 0.5 to 3.0 Pa. In addition, a temperature of the atmosphere may not be controlled during the sputtering. It is preferable that the substrate to be sputtered is heated during the sputtering. Other conditions of the sputtering may be referred to the above-described electron transport layer-forming step.

Examples of the step of forming an n-type oxide semiconductor by a method other than the sputtering method include a chemical solution deposition method and an atomic layer deposition method. These methods are known in the related art.

(Second electrode layer-forming step)

In a second electrode layer-forming step, for example, the second electrode layer 105 may be formed on the electron transport layer 104 or the second electron transport layer 202. Examples of a method of forming the second electrode layer 105 include the dry process and the wet process, and the dry process is preferable. The dry process is not particularly limited, and examples thereof include a method of forming the second electrode layer 105 that is the transparent electrode layer by a sputtering method. Deposition conditions of the sputtering method are not particularly limited, and may be, for example, applied power: 0.5 to 3.0 $W/cm^2$, deposition atmosphere: argon atmosphere, and deposition pressure: 0.5 to 3.0 Pa. In addition, a temperature of the atmosphere and a temperature of a substrate to be sputtered during the sputtering may not be controlled.

(Grid electrode-forming step)

In a grid electrode-forming step, for example, the grid electrode 106 may be formed on the second electrode layer 105. Examples of a method of forming the grid electrode 106 include the dry process and the wet process. Specific examples thereof include a sputtering method, a vapor deposition method, a method of printing a paste-like conductive material on the second electrode layer 105, and a method of crimping a conductive wire.

[Method of using solar cell]

The solar cell according to the present embodiment can be used in a normal temperature environment in which the temperature of the solar cell is approximately 45°C to 85°C, as in the solar cell in the related art. In addition, the solar cell according to the present embodiment can be suitably used in a high-temperature thermal environment in which the temperature of the solar cell exceeds 85°C (for example, in space, in the stratosphere, in deserts, in tropical regions, on rooftops of buildings, on roofs of automobiles, or on outer walls of airplanes), unlike the solar cell in the related art.
In addition, the solar cell according to the present embodiment can be used as an independent power supply device for streetlights, sensors, digital signage, and the like. In addition, the solar cell according to the present embodiment can be used as a mobile energy device.

[Addenda]

The embodiment according to the present disclosure includes the following aspects.

[1] A method for manufacturing a solar cell, including:
a step of forming an electron transport layer on a substrate including a light absorption layer by depositing an n-type oxide semiconductor by a sputtering method while supplying a gas including an oxygen source and a hydrogen source.
[2] The manufacturing method according to [1],
in which an open-circuit voltage of the manufactured solar cell under standard test conditions is 70% or more, preferably 80% or more of that of a solar cell in which an electron transport layer that is an n-type oxide semiconductor is formed by a chemical solution deposition method instead of the step of forming the electron transport layer.
[3] The manufacturing method according to [1] or [2],
in which the substrate includes, on an outermost layer, the light absorption layer or a second electron transport layer consisting of a material different from the n-type oxide semiconductor.
[4] The manufacturing method according to any one of [1] to [3],

in which the substrate includes the light absorption layer on an outermost layer, and
the light absorption layer comprises a chalcopyrite compound, a kesterite compound, or a perovskite compound.

[5] The manufacturing method according to any one of [1] to [4],
in which a concentration of the oxygen source in the gas supplied in the step is 0.12% by volume or more and 2.0% by volume or less, preferably 0.8% by volume or more and 1.6% by volume or less in terms of oxygen molecules.
[6] The manufacturing method according to any one of [1] to [5],
in which a molar ratio of the hydrogen element to an oxygen element in the gas supplied in the step is 0.60 times or more and 4.0 times or less, preferably 1.0 times or more and 2.0 times or less.

[7] The manufacturing method according to any one of [1] to [6],
in which the n-type oxide semiconductor is an oxide semiconductor having a band gap of 3.3 eV or more and a carrier concentration of $1.0 \times 10^{20}$ cm$^{-3}$ or less.
[8] The manufacturing method according to [7],
in which the n-type oxide semiconductor is zinc oxide, tin oxide, titanium oxide, zinc oxysulfide, magnesium zinc oxide, tin zinc oxide, or titanium zinc oxide.
[9] The manufacturing method according to any one of [1] to [8],

in which the n-type oxide semiconductor is titanium zinc oxide, and
the depositing is performed using a mixture of zinc oxide and titanium oxide, which contains 4.0% by mass or more and 20% by mass or less of the titanium oxide, as a sputtering target.

[10] The manufacturing method according to [9],
in which the depositing is performed while heating the substrate to 100°C or higher and 200°C or lower.
[11] A solar cell including at least, in the following order:

a first electrode layer;
a light absorption layer;
an electron transport layer being an n-type oxide semiconductor to which a hydrogen element is added; and
a second electrode layer.

[12] The solar cell according to [11],
in which the electron transport layer is positioned on the light absorption layer.
[13] The solar cell according to [11], further including:
a second electron transport layer consisting of a material different from the electron transport layer that is the n-type oxide semiconductor to which a hydrogen element is added, between the light absorption layer and the second electrode layer.
[14] The solar cell according to [13],
in which the second electron transport layer is positioned between the light absorption layer and the electron transport layer being the n-type oxide semiconductor to which a hydrogen element is added.
[15] The solar cell according to any one of [11] to [14],
in which the light absorption layer comprises a chalcopyrite compound, a kesterite compound, or a perovskite compound.
[16] The solar cell according to any one of [11] to [15],
in which the n-type oxide semiconductor is an oxide semiconductor having a band gap of 3.3 eV or more and a carrier concentration of $1.0 \times 10^{20}$ cm$^{-3}$ or less.
[17] The solar cell according to [16],
in which the n-type oxide semiconductor is zinc oxide, tin oxide, titanium oxide, zinc oxysulfide, magnesium zinc oxide, tin zinc oxide, or titanium zinc oxide. Examples

The present invention will be described in detail by Examples and Comparative Examples. The present invention is not limited by Examples.

[Example 1]

(Method for producing solar cell)

A solar cell in which one electron transport layer was provided, as illustrated in Figure 1, was produced. A titanium foil having a thickness of 50 $\mu$m was used as the substrate 107. On the substrate 107, the first electrode layer 101 containing metal molybdenum was formed by a sputtering method at a thickness of 600 nm.
Next, the light absorption layer 103 including a sodium element and a potassium element that are alkali metal elements and containing the CIGSS compound was formed on the first electrode layer 101 by a sputtering method at a thickness of 2 $\mu$m. In addition, when forming the light absorption layer 103, the hole transport layer 102 containing molybdenum selenide was formed between the first electrode layer 101 and the light absorption layer 103 at a thickness of 50 nm.
Next, the electron transport layer 104 that is an n-type oxide semiconductor containing zinc oxide to which a hydrogen element was added and a titanium element was added was formed on the light absorption layer 103 by a sputtering method at a thickness of 100 nm. Conditions of the sputtering method were as follows.

Sputtering target: mixture of zinc oxide and titanium oxide (the content of titanium oxide was set to 14% by mass)
Deposition atmosphere: argon/hydrogen gas/oxygen gas atmosphere (the sputtering was performed under a plurality of conditions of the volume concentration of the oxygen gas in the supplied mixed gas of 0.12% by volume to 1.6% by volume; in addition, the sputtering was performed under a plurality of conditions of a volume ratio of the hydrogen gas to the oxygen gas of 0.67 to 4.0)
Heating temperature of substrate to be sputtered during deposition: 160°C

When the amount of the hydrogen element in the electron transport layer 104 formed under the condition that the volume concentration of the hydrogen gas in the supplied mixed gas was 1.6% by volume and the volume concentration of the oxygen gas was 1.2% by volume was measured by an RBS/HFS method, a molar ratio of the hydrogen element to all metal elements was 0.011.

Next, the second electrode layer 105 that is a transparent electrode layer containing hydrogen-containing indium oxide (IOH) was formed on the electron transport layer 104 by a sputtering method at a thickness of 300 nm.

(Estimation of deposition damage)

First, a solar cell of a control example was produced. The first electrode layer and the light absorption layer were formed on the substrate in the same manner as in Example 1. Thereafter, the electron transport layer that is an n-type oxide semiconductor containing cadmium sulfide was formed on the light absorption layer by a chemical solution deposition method at a thickness of 100 nm. Thereafter, the second electrode layer was formed on the electron transport layer. The method of forming the second electrode layer was the same as that in Example 1.

The electron transport layer was formed by a chemical solution deposition method as follows. That is, after an aqueous solution containing cadmium sulfate, thiourea, and ammonia was put into a beaker, the surface of the light absorption layer was immersed in the solution, and then the electron transport layer that is the n-type oxide semiconductor was formed while gradually heating the aqueous solution from room temperature.

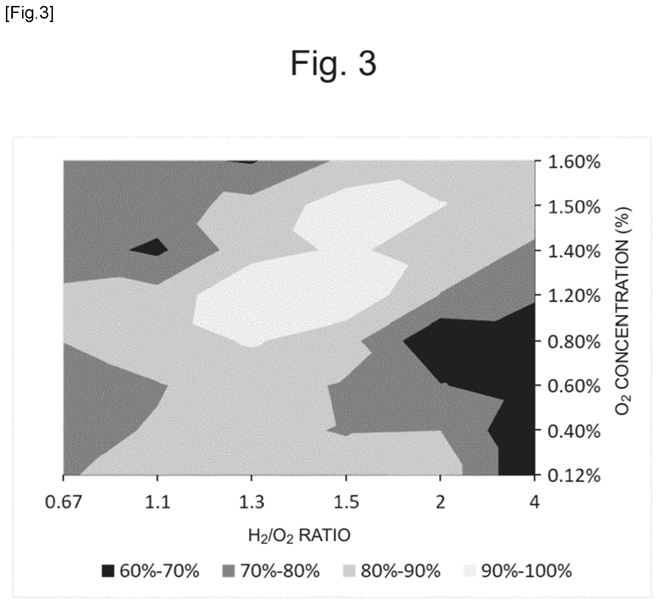

Next, an open-circuit voltage ($V_{oc}$) of the solar cell of the control example and an open-circuit voltage the solar cell produced under each of conditions of Example 1 were measured. The open-circuit voltage can be obtained from an I-V curve. Specifically, an intersection of the I-V curve and the x-axis (voltage axis) on the graph is $V_{oc}$. An I-V curve was measured under standard test conditions of the solar cell (test conditions in which light having an AM 1.5 solar spectrum was incident at an irradiance of 1 kW/m$^2$ and the solar cell temperature was 25°C). The open-circuit voltage of the solar cell produced under each of conditions of Example 1 was divided by the open-circuit voltage of the solar cell of the control example to calculate a remaining factor of open-circuit voltage. Table 1 shows a relationship among the volume concentration of the oxygen gas in the mixed gas supplied in the sputtering step, the volume ratio of the oxygen gas to the hydrogen gas, and the remaining factor of open-circuit voltage. In Table 1, the values emphasized in bold and underlined are measured values, and the other values are average values of at least two adjacent values. In addition, Figure 3 illustrates a graph created by linear interpolation based on Table 1. In Examples 2 and 3, a condition in which the volume concentration of the hydrogen gas was 1.6% by volume and the volume concentration of the oxygen gas was 1.2% by volume (the volume ratio of the hydrogen gas to the oxygen gas was 1.3) was adopted.

[Table 1]

| Remaining factor of open-circuit voltage | | H₂/O₂ ratio | | | | | |
|---|---|---|---|---|---|---|---|
| | | 0.67 | 1.1 | 1.3 | 1.5 | 2 | 4 |
| O₂ concentration (%) | 1.60% | 74% | 72% | **69%** | 82% | 86% | 85% |
| | 1.50% | 75% | 76% | 83% | **95%** | 90% | 84% |
| | 1.40% | 75% | **68%** | 86% | **92%** | 86% | 79% |
| | 1.20% | 82% | 83% | **99%** | **99%** | 80% | 71% |
| | 0.80% | 80% | 85% | 91% | 84% | **61%** | 63% |
| | 0.60% | **76%** | 80% | **83%** | 79% | 70% | 65% |
| | 0.40% | 78% | 81% | 82% | 80% | **80%** | 60% |
| | 0.12% | 80% | 81% | 82% | 83% | **86%** | **40%** |

[Example 2]

(Method for producing solar cell)

A plurality of solar cells was produced by the method of producing the solar cell of Example 1, by changing the thickness of the electron transport layer that is the n-type oxide semiconductor containing zinc oxide to which a titanium element was added, the proportion of titanium oxide in the sputtering target, and the heating temperature of the substrate to be sputtered during deposition (refer to Table 2 and Table 3 for each condition).

(Conversion efficiency)

First, a solar cell of a control example was produced. The solar cell of the control example was produced in the same manner as in Example 1 except for the electron transport layer. In the solar cell of the control example, an n-type semiconductor containing cadmium sulfide was formed as the electron transport layer on the light absorption layer by a chemical solution deposition method at a thickness of 70 nm.
Next, the conversion efficiency of the solar cell of Example 2 and the conversion efficiency of the solar cell of the control example were measured. An I-V curve was measured under standard test conditions of the solar cell (test conditions in which light having an AM 1.5 solar spectrum was incident at an irradiance of 1 kW/m$^2$ and the solar cell temperature was 25°C). The conversion efficiency of each solar cell was calculated by the following expression. The conversion efficiency is a value obtained by dividing the output (maximum output: $P_{max}$) at the optimal operation point in the I-V curve by light energy E received by the solar cell.

$$\text{Conversion efficiency (\%)} = P_{max} \div E \times 100$$

The conversion efficiency of the solar cell produced under each condition of Example 2 was divided by the conversion efficiency of the solar cell of the control example to calculate a conversion efficiency ratio. Table 2 and Table 3 show a relationship among the thickness of the electron transport layer that is the n-type oxide semiconductor including zinc oxide to which a titanium element was added, the proportion of titanium oxide in the sputtering target or the heating temperature of the substrate to be sputtered during deposition, and the conversion efficiency ratio. In the tables, "-" indicates that the solar cell was not produced.

[Table 2]

| Conversion efficiency ratio (%) | | Film thickness of electron transport layer ZnTiO$_x$ (nm) *TiO$_2$ concentration 14 wt% | |
|---|---|---|---|
| ZnTiO$_x$ efficiency/CdS efficiency | | 100 | 125 |
| Deposition temperature (°C) | 160 | 117% | 116% |
| | 195 | 110% | - |

[Table 3]

| Conversion efficiency ratio (%) | | Film thickness of electron transport layer ZnTiOx (nm) *Deposition temperature 160°C | | | |
|---|---|---|---|---|---|
| ZnTiO$_x$ efficiency/CdS efficiency | | 70 | 90 | 100 | 120 |
| TiO$_2$ concentraion (wt%) | 10 | - | 100% | 99% | 95% |
| | 14 | 94% | - | 91% | - |
| | 18 | - | - | 103% | - |

[Example 3]

(Method for producing solar cell)

A solar cell in which two electron transport layers were provided, as illustrated in Figure 2, was produced. A solar cell was produced in the same manner as in Example 1, except that two electron transport layers were formed.

The electron transport layers were formed as follows. First, the first electron transport layer 201 that is an n-type semiconductor containing indium sulfide or an n-type semiconductor containing cadmium sulfide was formed on the light absorption layer 103 at a thickness of 30 nm. The n-type semiconductor containing cadmium sulfide was formed by a chemical solution deposition method. The n-type semiconductor containing indium sulfide was formed by a sputtering method. Conditions of the sputtering method were as follows.

Sputtering target: indium sulfide
Deposition atmosphere: argon atmosphere
Heating temperature of substrate to be sputtered during deposition: 200°C

Next, the second electron transport layer 202 that is an n-type oxide semiconductor containing zinc oxide to which a hydrogen element was added and a titanium element was added was formed on the first electron transport layer 201 by a sputtering method. The second electron transport layer 202 was formed in the same manner as the electron transport layer in Example 1, except that the thickness of the n-type oxide semiconductor (second electron transport layer 202), the proportion of titanium oxide in the sputtering target, and/or the heating temperature of the substrate to be sputtered during deposition were changed to each value in Table 4 and Table 5.

The conversion efficiency of the solar cell produced under each condition was measured in the same manner as in Example 2. In addition, similarly, a conversion efficiency ratio with respect to the solar cell of the control example, including the electron transport layer that is the n-type semiconductor containing cadmium sulfide, was calculated. The results are shown in Table 4 and Table 5. In the tables, "-" indicates that the solar cell was not produced, and "RT" indicates room temperature.

[Table 4]

| Conversion efficiency ratio (%) | | Film thickness of second electron transport layer ZnTiO$_x$ (nm) *First electron transport layer CdS 30nm | |
|---|---|---|---|
| ZnTiO$_x$ efficiency/CdS efficiency | | 60 | 80 |
| Deposition temperature (°C) | RT | 87% | - |
| | 120 | 96% | - |
| | 160 | 101% | 110% |

[Table 5]

| Conversion efficiency (%) | | Film thickness of second electron transport layer ZnTiOx (nm) *First electron transport layer In$_2$S$_3$ 30nm | | |
|---|---|---|---|---|
| | | 70 | 90 | 120 |
| TiO$_2$ concentraion (wt%) | 6 | - | 16.2% | 16.9% |
| | 10 | 15.5% | 15.5% | - |

**Reference Signs List**

100, 200: solar cell

101: first electrode layer

102: hole transport layer

103: light absorption layer

104: electron transport layer

105: second electrode layer

106: grid electrode

107: substrate

201: first electron transport layer

202: second electron transport layer

**Claims**

1.  A method for manufacturing a solar cell, comprising:
    a step of forming an electron transport layer on a substrate including a light absorption layer by depositing an n-type oxide semiconductor by a sputtering method while supplying a gas including an oxygen source and a hydrogen source.

2.  The manufacturing method according to Claim 1,
    wherein an open-circuit voltage of the manufactured solar cell under standard test conditions is 70% or more of that of a solar cell in which an electron transport layer that is an n-type oxide semiconductor is formed by a chemical solution deposition method instead of the step of forming the electron transport layer.

3.  The manufacturing method according to Claim 1 or 2,
    wherein the substrate includes, on an outermost layer, the light absorption layer or a second electron transport layer consisting of a material different from the n-type oxide semiconductor.

4.  The manufacturing method according to any one of Claims 1 to 3,

    wherein the substrate includes the light absorption layer on an outermost layer, and
    the light absorption layer comprises a chalcopyrite compound, a kesterite compound, or a perovskite compound.

5.  The manufacturing method according to any one of Claims 1 to 4,
    wherein a concentration of the oxygen source in the gas supplied in the step is 0.12% by volume or more and 2.0% by volume or less in terms of oxygen molecules.

6.  The manufacturing method according to any one of Claims 1 to 5,
    wherein a molar ratio of a hydrogen element to an oxygen element in the gas supplied in the step is 0.60 times or more and 4.0 times or less.

7.  The manufacturing method according to any one of Claims 1 to 6,
    wherein the n-type oxide semiconductor is an oxide semiconductor having a band gap of 3.3 eV or more and a carrier concentration of $1.0 \times 10^{20}$ $cm^{-3}$ or less.

8.  The manufacturing method according to Claim 7,
    wherein the n-type oxide semiconductor is zinc oxide, tin oxide, titanium oxide, zinc oxysulfide, magnesium zinc oxide, tin zinc oxide, or titanium zinc oxide.

9.  The manufacturing method according to any one of Claims 1 to 8,

    wherein the n-type oxide semiconductor is titanium zinc oxide, and
    the depositing is performed using a mixture of zinc oxide and titanium oxide which contains 4.0% by mass or more and 20% by mass or less of the titanium oxide as a sputtering target.

10. The manufacturing method according to Claim 9,
    wherein the depositing is performed while heating the substrate to 100°C or higher and 200°C or lower.

11. A solar cell comprising at least, in the following order:

    a first electrode layer;

a light absorption layer;
an electron transport layer being an n-type oxide semiconductor to which a hydrogen element is added; and
a second electrode layer.

12. The solar cell according to Claim 11,
wherein the electron transport layer is positioned on the light absorption layer.

13. The solar cell according to Claim 11 or 12, further comprising:
a second electron transport layer consisting of a material different from the electron transport layer that is the n-type oxide semiconductor to which a hydrogen element is added, between the light absorption layer and the second electrode layer.

14. The solar cell according to Claim 13,
wherein the second electron transport layer is positioned between the light absorption layer and the electron transport layer being the n-type oxide semiconductor to which a hydrogen element is added.

15. The solar cell according to any one of Claims 11 to 14,
wherein the light absorption layer comprises a chalcopyrite compound, a kesterite compound, or a perovskite compound.

16. The solar cell according to any one of Claims 11 to 15,
wherein the n-type oxide semiconductor is an oxide semiconductor having a band gap of 3.3 eV or more and a carrier concentration of $1.0 \times 10^{20}$ cm$^{-3}$ or less.

17. The solar cell according to Claim 16,
wherein the n-type oxide semiconductor is zinc oxide, tin oxide, titanium oxide, zinc oxysulfide, magnesium zinc oxide, tin zinc oxide, or titanium zinc oxide.

[Fig.1]

Fig. 1

[Fig.2]

# Fig. 2

[Fig.3]

# Fig. 3

## INTERNATIONAL SEARCH REPORT

| International application No. |
| --- |
| **PCT/JP2024/032300** |

| | |
| --- | --- |
| **A.** | **CLASSIFICATION OF SUBJECT MATTER** |

*H01L 31/18*(2006.01)i; *H01L 31/0749*(2012.01)i; *H10K 30/40*(2023.01)i; *H10K 30/50*(2023.01)i; *H10K 30/85*(2023.01)i
FI:   H01L31/04 420; H10K30/40; H10K30/50; H10K30/85; H01L31/06 460

According to International Patent Classification (IPC) or to both national classification and IPC

| | |
| --- | --- |
| **B.** | **FIELDS SEARCHED** |

Minimum documentation searched (classification system followed by classification symbols)

H01L31/18; H01L31/0749; H10K30/40; H10K30/50; H10K30/85

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| Y | JP 2013-229506 A (SHARP KABUSHIKI KAISHA) 07 November 2013 (2013-11-07) claims 1-4, 6-7, paragraphs [0027]-[0032], [0062]-[0073], fig. 1 | 1, 4, 7, 11-12, 15-16 |
| Y | JP 2015-18959 A (IDEMITSU KOSAN CO., LTD.) 29 January 2015 (2015-01-29) paragraphs [0002]-[0044] | 1-17 |
| Y | JP 2021-057605 A (SEMICONDUCTOR ENERGY LABORATORY CO., LTD.) 08 April 2021 (2021-04-08) paragraphs [0453]-[0456] | 7, 16 |
| Y | WO 2021/181842 A1 (PANASONIC INTELLECTUAL PROPERTY MANAGEMENT CO., LTD.) 16 September 2021 (2021-09-16) paragraphs [0021], [0046], [0054], [0064], [0070], [0091]-[0093], fig. 1-2 | 1-17 |
| Y | JP 2017-119805 A (ORIENT CHEMICAL IND CO., LTD.) 06 July 2017 (2017-07-06) paragraph [0102] | 1-17 |

✓ Further documents are listed in the continuation of Box C.          ✓ See patent family annex.

| | |
| --- | --- |
| *     Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **15 October 2024** | **29 October 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**EP 4 780 170 A1**

**INTERNATIONAL SEARCH REPORT**

| International application No. |
| --- |
| **PCT/JP2024/032300** |

### C. DOCUMENTS CONSIDERED TO BE RELEVANT

| Category* | Citation of document, with indication, where appropriate, of the relevant passages | Relevant to claim No. |
| --- | --- | --- |
| Y | JP 2017-126731 A (PANASONIC CORPORATION) 20 July 2017 (2017-07-20) paragraph [0029] | 3, 13-14 |

Form PCT/ISA/210 (second sheet) (July 2022)

**INTERNATIONAL SEARCH REPORT**
Information on patent family members

International application No.

**PCT/JP2024/032300**

| Patent document cited in search report | | | Publication date (day/month/year) | Patent family member(s) | Publication date (day/month/year) |
|---|---|---|---|---|---|
| JP | 2013-229506 | A | 07 November 2013 | (Family: none) | |
| JP | 2015-18959 | A | 29 January 2015 | (Family: none) | |
| JP | 2021-057605 | A | 08 April 2021 | US 2017/0179294 A1 paragraphs [0494]-[0498] | |
| WO | 2021/181842 | A1 | 16 September 2021 | US 2022/0416099 A1 paragraphs [0022], [0047], [0071], [0081], [0087], [0115]-[0117], fig. 1-2 CN 115152042 A | |
| JP | 2017-119805 | A | 06 July 2017 | (Family: none) | |
| JP | 2017-126731 | A | 20 July 2017 | US 2016/0359119 A1 paragraph [0034] CN 106252512 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E.B. YOUSFI et al.** Cadmium-free buffer layers deposited by atomic layer epitaxy for copper indium diselenide solar cells. *Thin Solid Films*, 2000, vol. 361-362, 183-186

- **SOUMYADEEP SINHA et al.** A review on atomic layer deposited buffer layers for Cu(In,Ga) Se2(CIGS) thin film solar cells: Past, present, and future. *Solar Energy*, 2020, vol. 209, 515-537